(19) 

**Europäisches Patentamt**
**European Patent Office**
**Office européen des brevets**

(11)  **EP 4 488 700 A1**

(12) **EUROPEAN PATENT APPLICATION**
published in accordance with Art. 153(4) EPC

(43) Date of publication:
**08.01.2025 Bulletin 2025/02**

(21) Application number: **23770381.4**

(22) Date of filing: **28.02.2023**

(51) International Patent Classification (IPC):
*G01R 31/392* (2019.01)   *G01R 31/374* (2019.01)
*G01R 31/3828* (2019.01)   *G01R 31/385* (2019.01)
*H01M 10/42* (2006.01)   *H01M 10/48* (2006.01)
*H02J 7/00* (2006.01)

(52) Cooperative Patent Classification (CPC):
**G01R 31/374; G01R 31/3828; G01R 31/385;**
**G01R 31/392; H01M 10/42; H01M 10/48; H02J 7/00**

(86) International application number:
**PCT/JP2023/007241**

(87) International publication number:
**WO 2023/176423 (21.09.2023 Gazette 2023/38)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **15.03.2022 JP 2022039897**

(71) Applicant: **Mitsubishi Jidosha Kogyo Kabushiki**
**Kaisha**
**Tokyo 108-8410 (JP)**

(72) Inventors:
• **SAEKI, Hajime**
  **Tokyo 108-8410 (JP)**
• **YOKOTSUJI, Hokuto**
  **Tokyo 108-8410 (JP)**

• **ISHIKAWA, Kiyotaka**
  **Tokyo 108-8410 (JP)**
• **INOUE, Masahiro**
  **Tokyo 108-8410 (JP)**
• **KANO, Yasuaki**
  **Tokyo 108-8410 (JP)**
• **TANAKA, Hayate**
  **Tokyo 108-8410 (JP)**
• **SHINYA, Masanori**
  **Tokyo 108-8410 (JP)**
• **TAJIKARA, Akihiro**
  **Tokyo 108-8410 (JP)**
• **YAGI, Satsuki**
  **Tokyo 108-8410 (JP)**

(74) Representative: **Vossius & Partner**
**Patentanwälte Rechtsanwälte mbB**
**Siebertstrasse 3**
**81675 München (DE)**

(54) **BATTERY DEGRADATION AMOUNT DETERMINATION METHOD, BATTERY MANAGEMENT UNIT, AND BATTERY PACK**

(57)      There is provided, at least, a method including: acquiring battery data including temperature data indicating a temperature of a battery, SOC data indicating an SOC of the battery, and integrated current amount data indicating an integrated current amount due to charging and discharging of the battery; calculating a first deterioration amount which is a deterioration amount of the battery according to a first deterioration characteristic based on the battery data by using a first deterioration characteristic model; calculating a second deterioration amount which is a deterioration amount of the battery according to a second deterioration characteristic based on the battery data by using a second deterioration characteristic model; and calculating a deterioration amount of the battery based on the first deterioration amount and the second deterioration amount.

EP 4 488 700 A1

*FIG. 1*

120

| BATTERY DATA → | DETERIORATION CHARACTERISTIC A 123 | $Y_{a2}$ |
|---|---|---|
| BATTERY DATA → | DETERIORATION CHARACTERISTIC B 124 | $Y_{b2}$ |
| BATTERY DATA → | DETERIORATION CHARACTERISTIC C 125 | $Y_{c2}$ |

$+$  $+$  $+$ → DETERIORATION AMOUNT Y OF BATTERY

**Description**

TECHNICAL FIELD

The present disclosure relates to a method for determining a battery deterioration amount, a battery management unit, and a battery pack.

BACKGROUND ART

Patent Literature 1 discloses an estimation device that estimates a deterioration amount of a battery. The estimation device acquires a current capacity retention rate of the battery. When the capacity retention rate is equal to or larger than a threshold, the estimation device calculates the deterioration amount of the battery by using first approximate data. On the other hand, when the capacity retention rate is less than the threshold, the estimation device calculates the deterioration amount of the battery by using second approximate data.

CITATION LIST

PATENT LITERATURE

Patent Literature 1: JP2020-180935A

SUMMARY OF INVENTION

TECHNICAL PROBLEM

A deterioration amount of a battery is used to calculate a state of charge (SOC) of the battery. In order to further improve the accuracy of the SOC of the battery, it is preferable to further improve a method for determining a battery deterioration amount.
The present disclosure provides an improved method for determining a battery deterioration amount, a battery management unit, and a battery pack.

SOLUTION TO PROBLEM

According to an aspect of the present disclosure, a method for determining a battery deterioration amount includes: (a) a step of acquiring battery data including temperature data indicating a temperature of a battery, SOC data indicating an SOC of the battery, and integrated current amount data indicating an integrated current amount due to charging and discharging of the battery; (b) a step of calculating a first deterioration amount which is a deterioration amount of the battery according to a first deterioration characteristic based on the battery data by using a first deterioration characteristic model; (c) a step of calculating a second deterioration amount which is a deterioration amount of the battery according to a second deterioration characteristic based on the battery data by using a second deterioration characteristic model; and (d) a step of calculating a deterioration amount of the battery based on the first deterioration amount and the second deterioration amount. The first deterioration characteristic model defines an upper limit of the first deterioration amount. The second deterioration characteristic model does not define an upper limit of the second deterioration amount.
According to another aspect of the present disclosure, a battery management unit executes: (a) a process of acquiring battery data including temperature data indicating a temperature of a battery, SOC data indicating an SOC of the battery, and integrated current amount data indicating an integrated current amount due to charging and discharging of the battery; (b) a process of calculating a first deterioration amount which is a deterioration amount of the battery according to a first deterioration characteristic based on the battery data using a first deterioration characteristic model; (c) a process of calculating a second deterioration amount which is a deterioration amount of the battery according to a second deterioration characteristic based on the battery data using a second deterioration characteristic model; and (d) a process of calculating a deterioration amount of the battery based on the first deterioration amount and the second deterioration amount. The first deterioration characteristic model defines an upper limit of the first deterioration amount. The second deterioration characteristic model does not define an upper limit of the second deterioration amount.
According to another aspect of the present disclosure, a battery pack includes: a battery; a temperature sensor configured to detect a temperature of the battery and generate temperature data indicating the temperature of the battery; a voltage sensor configured to detect a voltage of the battery and generate voltage data indicating the voltage of the battery; a current sensor configured to detect a current due to charging and discharging of the battery and generate current data indicating the current of the battery; and a battery management unit connected to the temperature sensor, the voltage sensor, and the current sensor. The battery management unit (a) acquires the temperature data from the temperature sensor, (b) acquires the voltage data from the voltage sensor, (c) acquires the current data from the current sensor, (d) generates battery data including the temperature data, SOC data indicating an SOC of the battery, and integrated current amount data indicating an integrated current amount due to charging and discharging of the battery based on the temperature data, the voltage data, and the current data, (e) calculates a first deterioration amount which is a deterioration amount of the battery according to a first deterioration characteristic based on the battery data by using a first deterioration characteristic model, (f) calculates a second deterioration amount which is a deterioration amount of the battery according to a second deterioration characteristic based on the battery data by using a second deterioration characteristic model, and (g) calculates a deterioration amount of the battery based on the first deterioration amount and the second deterioration amount. The first deterioration characteristic model defines an upper limit of the first deterioration amount. The second deterioration characteristic model does not define an upper limit of the second deterioration amount.

ADVANTAGEOUS EFFECTS OF INVENTION

The present disclosure can provide the improved method for determining a battery deterioration amount, the battery management unit, and the battery pack.

BRIEF DESCRIPTION OF DRAWINGS

[FIG. 1] Fig. 1 is a functional block diagram showing a battery deterioration amount determination process according to an embodiment of the present disclosure;
[FIG. 2] Fig. 2 is a functional block diagram showing the battery deterioration amount determination process according to the embodiment of the present disclosure;
[FIG. 3] Fig. 3 is a diagram showing third map data used to determine an upper limit of a deterioration amount of a battery according to the embodiment of the present disclosure;
[FIG. 4] Fig. 4 is a diagram showing first map data used to determine a first coefficient for calculating the deterioration amount of the battery according to the embodiment of the present disclosure;
[FIG. 5] Fig. 5 is a diagram showing second map data used to determine a second coefficient for calculating the deterioration amount of the battery according to the embodiment of the present disclosure;
[FIG. 6] Fig. 6 is a flowchart showing the battery deterioration amount determination process according to the embodiment of the present disclosure;
[FIG. 7] Fig. 7 is a diagram for illustrating a process of constructing a deterioration characteristic model of the battery according to the embodiment of the present disclosure;
[FIG. 8] Fig. 8 is a diagram for illustrating the process of constructing the deterioration characteristic model of the battery according to the embodiment of the present disclosure;
[FIG. 9] Fig. 9 is a diagram showing a battery deterioration amount calculated by the battery deterioration amount determination process according to the embodiment of the present disclosure and a battery deterioration amount calculated by a battery deterioration amount determination process according to the related art; and
[FIG. 10] Fig. 10 is a functional block diagram showing an application example of a method for determining a battery deterioration amount according to the embodiment of the present disclosure.

DESCRIPTION OF EMBODIMENTS

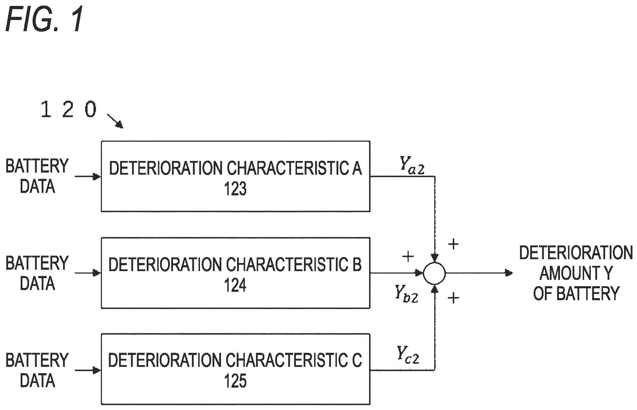

Fig. 1 shows a battery deterioration amount determination process according to an embodiment of the present disclosure. In the present embodiment, a battery deterioration amount determination process 120 includes deterioration characteristic models 123, 124, and 125. The deterioration characteristic model 123 receives battery data and calculates a deterioration amount $Y_{a2}$ of a battery according to a deterioration characteristic A of the battery based on the battery data. The deterioration characteristic model 124 receives battery data and calculates a deterioration amount $Y_{b2}$ of the battery according to a deterioration characteristic B of the battery based on the battery data. The deterioration characteristic model 125 receives battery data and calculates a deterioration amount $Y_{c2}$ of the battery according to a deterioration characteristic C of the battery based on the battery data. The battery deterioration amount determination process 120 calculates a battery deterioration amount Y based on the deterioration amount $Y_{a2}$ according to the deterioration characteristic A, the deterioration amount $Y_{b2}$ according to the deterioration characteristic B, and the deterioration amount $Y_{c2}$ according to the deterioration characteristic C. Specifically, the deterioration amount Y of the battery is the sum of the deterioration amount $Y_{a2}$, the deterioration amount $Y_{b2}$, and the deterioration amount $Y_{c2}$.

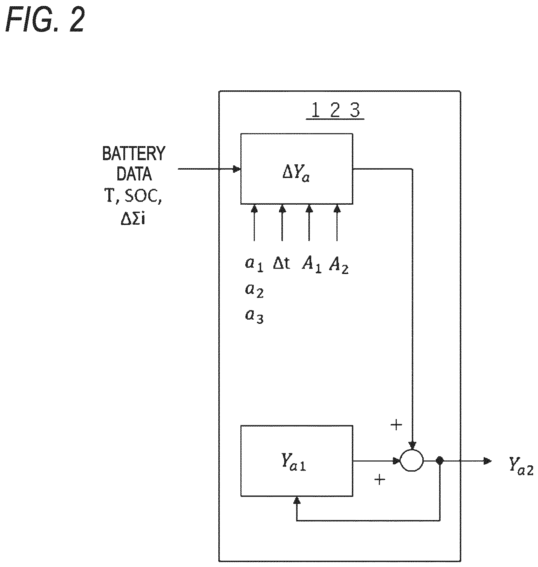

As shown in Fig. 2, in the present embodiment, the deterioration characteristic model 123 acquires a deteriora-

tion amount $Y_{a1}$ of the battery according to the deterioration characteristic A in a first period, calculates a deterioration amount $\Delta Y_a$ of the battery according to the deterioration characteristic A in a second period subsequent to the first period, and calculates the deterioration amount $Y_{a2}$ of the battery by adding the deterioration amount $\Delta Y_a$ in the second period to the deterioration amount $Y_{a1}$ in the first period. The deterioration amount $Y_{a2}$ of the battery is a deterioration amount accumulated over time.

Similarly, in the present embodiment, the deterioration characteristic model 124 acquires the deterioration amount $Y_{b1}$ of the battery according to the deterioration characteristic B in the first period, calculates a deterioration amount $\Delta Y_b$ of the battery according to the deterioration characteristic B in the second period, and calculates the deterioration amount $Y_{b2}$ of the battery by adding the deterioration amount $\Delta Y_b$ in the second period to the deterioration amount $Y_{b1}$ in the first period. The deterioration amount $Y_{b2}$ of the battery is a deterioration amount accumulated over time.

Similarly, in the present embodiment, the deterioration characteristic model 125 acquires a deterioration amount $Y_{c1}$ of the battery according to the deterioration characteristic C in the first period, calculates a deterioration amount $\Delta Y_c$ of the battery according to the deterioration characteristic C in the second period, and calculates the deterioration amount $Y_{c2}$ of the battery by adding the deterioration amount $\Delta Y_c$ in the second period to the deterioration amount $Y_{c1}$ in the first period. The deterioration amount $Y_{c2}$ of the battery is a deterioration amount accumulated over time.

In the present embodiment, the deterioration amount Y of the battery is expressed by the following equation.

[Formula 1]

$$Y = Y_{a2} + Y_{b2} + Y_{c2}$$

[Formula 2]

$$Y = (\Delta Y_a + Y_{a1}) + (\Delta Y_b + Y_{b1}) + (\Delta Y_c + Y_{c1})$$

In the present embodiment, the battery data includes temperature data indicating a temperature T of the battery in the second period, SOC data indicating an SOC of the battery in the second period, and integrated current amount data indicating an integrated current amount $\Delta\Sigma i$ due to charging and discharging of the battery in the second period.

The temperature T of the battery in the second period is a temperature at the beginning of the second period, a temperature at the end of the second period, a temperature in an intermediate period between the beginning and the end of the second period, an average of temperatures in a plurality of periods in the second period, and another temperature representing the second period.

The SOC of the battery in the second period is an SOC at the beginning of the second period, an SOC at the end of the second period, an SOC in an intermediate period between the beginning and the end of the second period, an average of SOCs in the plurality of periods in the second period, and another SOC representing the second period.

The integrated current amount $\Delta\Sigma i$ in the second period is an integration of currents sampled in the plurality of periods in the second period.

In the present embodiment, the deterioration characteristic model 123 defines an upper limit of the deterioration amount $Y_{a2}$ of the battery. The deterioration amount $Y_{a2}$ of the battery increases by the accumulation over time, and stops increasing when reaching the upper limit. The deterioration characteristic model 123 reflects, for example, a deterioration tendency due to electrode material characteristics of the battery.

Similarly, in the present embodiment, the deterioration characteristic model 124 defines an upper limit of the deterioration amount $Y_{b2}$ of the battery. The deterioration amount $Y_{b2}$ of the battery increases by the accumulation over time, and stops increasing when reaching the upper limit. The deterioration characteristic model 124 reflects, for example, a deterioration tendency due to the electrode material characteristics of the battery. In a certain battery, the upper limit of the deterioration amount $Y_{b2}$ of the battery is equal to the upper limit of the deterioration amount $Y_{a2}$ of the battery. In another battery, the upper limit of the deterioration amount $Y_{b2}$ of the battery is different from the upper limit of the deterioration amount $Y_{a2}$ of the battery.

In the present embodiment, the deterioration characteristic model 125 does not define an upper limit of the deterioration amount $Y_{c2}$ of the battery. The deterioration amount $Y_{c2}$ of the battery continues to increase by the accumulation over time.

The upper limit of the deterioration amount $Y_{a2}$ of the battery may be a fixed value or a variation value. The upper limit of the deterioration amount $Y_{b2}$ of the battery may be a fixed value or a variation value. In the present embodiment, both the upper limit of the deterioration amount $Y_{a2}$ of the battery and the upper limit of the deterioration amount $Y_{b2}$ of the battery are variation values.

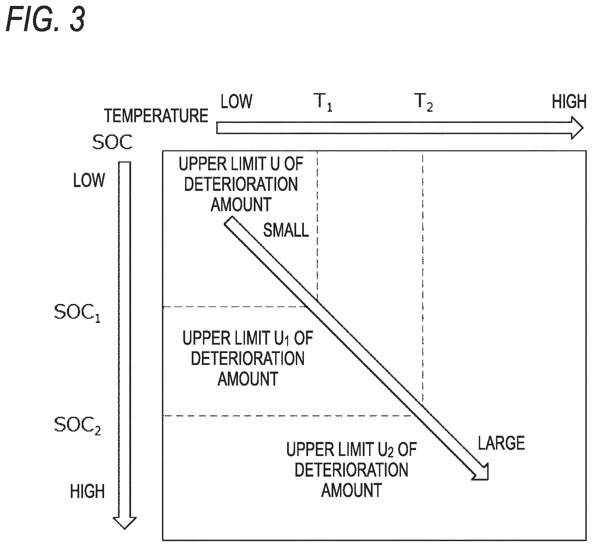

Fig. 3 shows third map data used to determine the upper limit of the deterioration amount $Y_{a2}$ of the battery. The third map data associates a plurality of temperature candidates, a plurality of SOC candidates, and a plurality of deterioration amount upper limit candidates with one another. For example, the third map data associates a temperature $T_1$, a $SOC_1$, and a deterioration amount upper limit Ui with one another. The third map data further associates a temperature $T_2$, a $SOC_2$, and a deterioration amount upper limit $U_2$ with one another. The temperature $T_2$ is higher than the temperature $T_1$. The $SOC_2$ is higher than the SOCi. The deterioration amount upper limit $U_2$ is larger than the deterioration amount upper limit Ui. Similarly, the deterioration amount $Y_{b2}$ of the battery may be determined by using map data. The map data for determining the deterioration amount $Y_{b2}$ of the battery is the same as or different from the map data for determining the deterioration amount $Y_{b1}$ of the battery.

In the present embodiment, the deterioration characteristic model 123 includes the following equation for calculating the deterioration amount $\Delta Y_a$ in the second period. The deterioration amount $\Delta Y_a$ is proportional to a square root of $\Delta t$. The deterioration amount $\Delta Y_a$ represents the deterioration amount of the battery due to an elapsed time.

[Formula 3]

$$\Delta Y_a = \left\{ a_1 + \exp\left(a_2 + \frac{a_3}{T}\right) \right\} \times \Delta t^{1/2} \times A1 \times A2$$

A coefficient $a_1$ is a fixed value. A coefficient $a_2$ is a fixed value. A coefficient $a_3$ is a fixed value. In a certain battery, the coefficients $a_1$, $a_2$, and $a_3$ are equal. In another battery, the coefficients $a_1$, $a_2$, and $a_3$ are different from one another. In still another battery, two of the coefficients $a_1$, $a_2$, and $a_3$ are equal. $\Delta t$ is a time length of the second period. A first coefficient A1 is a variation value for reflecting a utilization environment of the battery in the second period in the deterioration amount. A second coefficient A2 is a variation value for reflecting an electrode deterioration characteristic of the battery in the second period in the deterioration amount.

In the present embodiment, the deterioration characteristic model 124 includes the following equation for calculating the deterioration amount $\Delta Y_b$ in the second period. The deterioration amount $\Delta Y_b$ is proportional to the square root of $\Delta t$. The deterioration amount $\Delta Y_b$ represents the deterioration amount of the battery due to the elapsed time.

[Formula 4]

$$\Delta Y_b = \left\{ b_1 + \exp\left(b_2 + \frac{b_3}{T}\right) \right\} \times \Delta t^{1/2} \times B1 \times B2$$

A coefficient $b_1$ is a fixed value. A coefficient $b_2$ is a fixed value. A coefficient $b_3$ is a fixed value. In a certain battery, the coefficients bi, $b_2$, and $b_3$ are equal. In another battery, the coefficients bi, $b_2$, and $b_3$ are different from one another. In still another battery, two of the coefficients bi, $b_2$, and $b_3$ are equal. $\Delta t$ is a time length of the second period. A first coefficient B 1 is a variation value for reflecting the utilization environment of the battery in the second period in the deterioration amount. A second coefficient B2 is a variation value for reflecting the electrode deterioration characteristic of the battery in the second period in the deterioration amount.

In the present embodiment, the deterioration characteristic model 125 includes the following equations for calculating the deterioration amount $\Delta Y_c$ in the second period. The deterioration amount $\Delta Y_c$ includes a first term and a second term. The first term is proportional to the square root of $\Delta t$. The first term represents the deterioration amount of the battery due to the elapsed time. The second term is proportional to the square root of $\Delta \Sigma i$. The second term represents a deterioration amount of the battery (also referred to as a cycle deterioration amount) due to an integrated current amount factor.

[Formula 5]

$$\Delta Y_c = \left\{ c_1 + \exp\left(c_2 + \frac{c_3}{T}\right) \right\} \times \Delta t^{1/2} \times C1 + \left\{ c_4 + \exp\left(c_5 + \frac{c_6}{T}\right) \right\} \times \Delta \sum i^{1/2}$$

A coefficient $c_1$ is a fixed value. A coefficient $c_2$ is a fixed value. A coefficient $c_3$ is a fixed value. In a certain battery, the coefficients $c_1$, $c_2$, and $c_3$ are equal. In another battery, the coefficients $c_1$, $c_2$, and $c_3$ are different from one another. In still another battery, two of the coefficients $c_1$, $c_2$, and $c_3$ are equal. $\Delta t$ is a time length of the second period. A first coefficient C1 is a variation value for reflecting the utilization environment of the battery in the second period in the deterioration

amount. $\Delta\Sigma i$ is the integrated current amount in the second period.

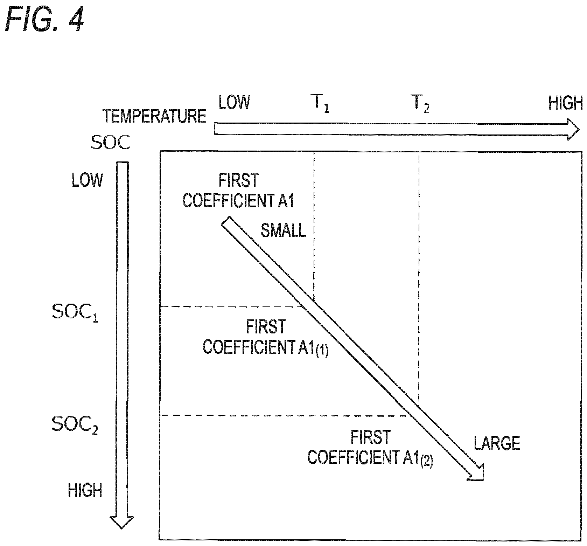

Fig. 4 shows first map data used to determine the first coefficient A1. The first map data associates the plurality of temperature candidates, the plurality of SOC candidates, and a plurality of first coefficient candidates with one another. For example, the first map data associates the temperature $T_1$, the $SOC_1$, and a first coefficient $A1_{(1)}$ with one another. The first map data further associates the temperature $T_2$, the $SOC_2$, and a first coefficient $A1_{(2)}$ with one another. The temperature $T_2$ is higher than the temperature $T_1$. The $SOC_2$ is higher than the $SOC_i$. The first coefficient $A1_{(2)}$ is larger than the first coefficient $A1_{(1)}$. Generally, the deterioration amount of the battery depends on the temperature of the battery and the SOC of the battery. The first map data reflects the utilization environment of the deterioration amount of the battery.

Similarly, the first coefficient B1 may be determined by map data. In a certain battery, the map data for determining the first coefficient B1 is the same as the map data for determining the first coefficient A1. In another battery, the map data for determining the first coefficient B1 is different from the map data for determining the first coefficient Al.

Similarly, the first coefficient C1 may be determined by map data. In a certain battery, the map data for determining the first coefficient C1 is the same as the map data for determining the first coefficient A1. In another battery, the map data for determining the first coefficient C1 is different from the map data for determining the first coefficient Al.

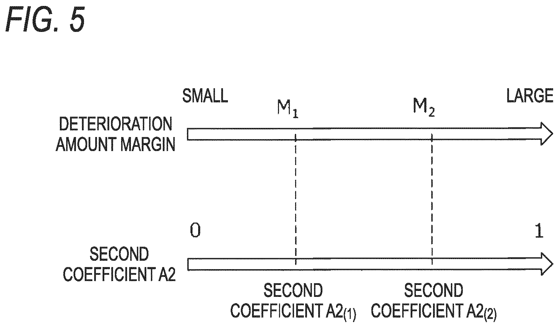

Fig. 5 shows second map data used to determine the second coefficient A2. The second map data associates a plurality of deterioration amount margin candidates with a plurality of second coefficient candidates. For example, the second map data associates a deterioration amount margin $M_1$ with a second coefficient $A2(i)$. The second map data associates a deterioration amount margin $M_2$ with a second coefficient $A2_{(2)}$. The deterioration amount margin $M_2$ is larger than the deterioration amount margin $M_1$. The second coefficient $A2_{(2)}$ is larger than the second coefficient $A2(i)$.

The deterioration amount margin may be calculated based on the upper limit of the battery deterioration amount, the cycle deterioration amount, and the deterioration amount in the first period. For example, the deterioration amount margin may be calculated by subtracting the cycle deterioration amount and the deterioration amount in the first period from the upper limit of the battery deterioration amount.

In the present embodiment, the second coefficient A2 takes a value within a range of 0 or more and 1 or less. For example, when the deterioration amount margin is zero, the second coefficient A2 is zero. When the second coefficient A2 becomes zero, the deterioration amount $\Delta Y_a$ in the second period becomes zero. Since the deterioration amount $\Delta Y_a$ in the second period becomes zero, the deterioration amount $Y_{a2}$ of the battery becomes equal to the deterioration amount $Y_{a1}$ in the first period. That is, when the deterioration amount margin is zero, the increase in the deterioration amount $Y_{a2}$ of the battery stops.

Similarly, the second coefficient B2 may be determined by map data. In a certain battery, the map data for determining the second coefficient B2 is the same as the map data for determining the second coefficient A2. In another battery, the map data for determining the second coefficient B2 is different from the map data for determining the second coefficient A2.

In the present embodiment, similarly to the second coefficient A2, the second coefficient B2 takes a value within a range of 0 or more and 1 or less. For example, when the deterioration amount margin is zero, the second coefficient B2 is zero. When the deterioration amount margin is zero, the increase in the deterioration amount $Y_{b2}$ of the battery stops.

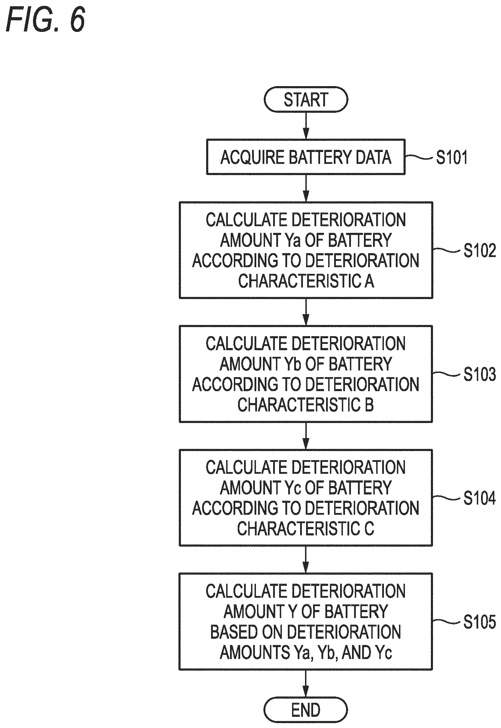

Fig. 6 shows a flow of the battery deterioration amount determination process in the second period. The battery deterioration amount determination process is repeated at a constant sampling cycle.

In step S101, the battery data is acquired. As described above, the battery data includes the temperature data, the SOC data, and the integrated current amount data.

In step S102, a deterioration amount $Y_a$ of the battery according to the deterioration characteristic A is calculated. As described above, the deterioration amount $Y_a$ of the battery is calculated based on the battery data by using the deterioration characteristic model 123.

In step S103, the deterioration amount $Y_b$ of the battery according to the deterioration characteristic B is calculated. As described above, the deterioration amount $Y_b$ of the battery is calculated based on the battery data by using the deterioration characteristic model 124.

In step S104, a deterioration amount $Y_c$ of the battery according to the deterioration characteristic C is calculated. As described above, the deterioration amount $Y_c$ of the battery is calculated based on the battery data by using the deterioration characteristic model 125.

In step S105, the deterioration amount Y of the battery is calculated based on the deterioration amounts $Y_a$, $Y_b$, and $Y_c$.

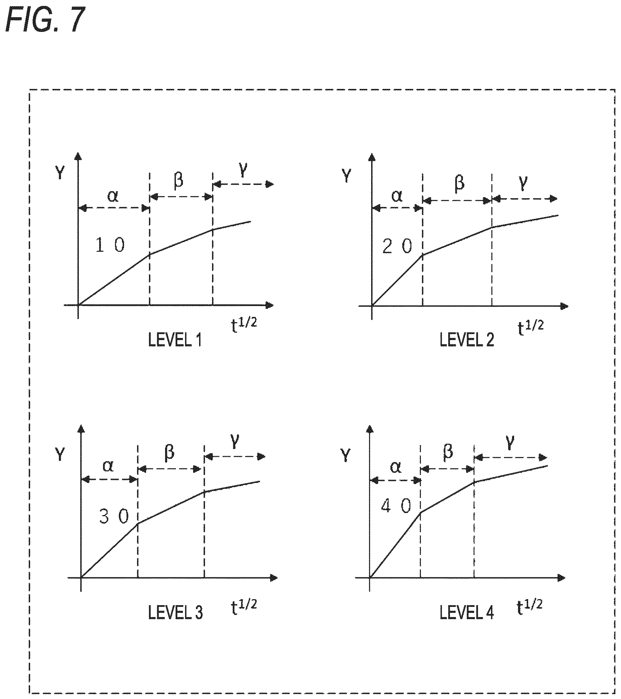

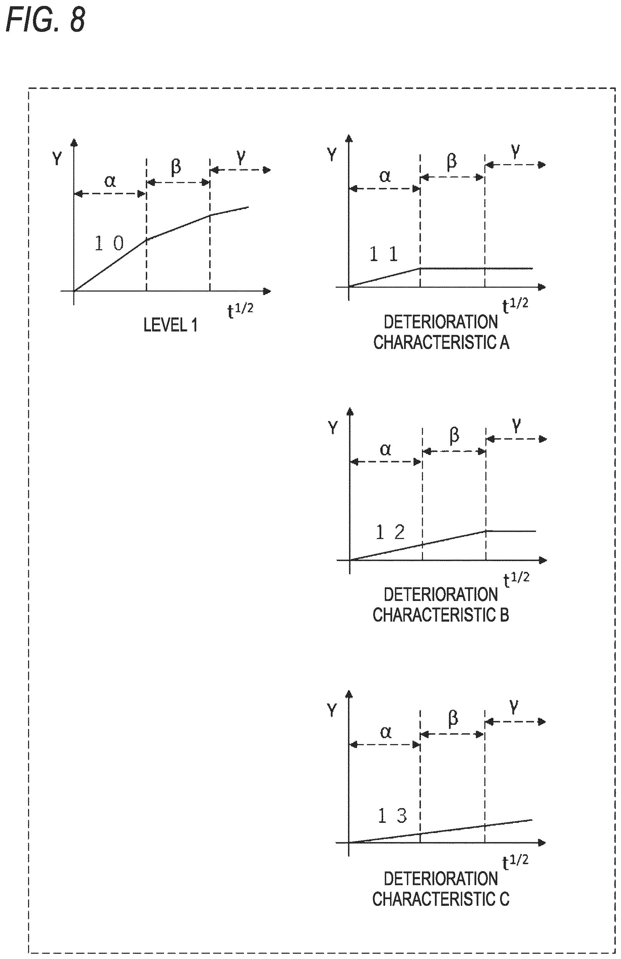

Figs. 7 and 8 show a process of constructing a deterioration characteristic model of the battery. First, deterioration curve data indicating changes over time of the deterioration amount of the battery is obtained by an experiment. The experiment is conducted at a plurality of different levels. For example, level 1 is a combination of a low temperature and a low SOC. In level 1, a deterioration curve 10 is obtained. Level 2 is a combination of the low temperature and a high SOC. At level 2, a deterioration curve 20 is obtained. Level 3 is a combination of a high temperature and the low SOC. In level 3, a deterioration curve 30 is obtained. Level 4 is a combination of the high temperature and the high SOC. In level 4, a deterioration curve 40 is obtained.

As shown in Fig. 7, in the present embodiment, each of the deterioration curves 10, 20, 30, and 40 includes two inflection points. That is, each of the deterioration curves 10, 20, 30, and 40 includes a period $\alpha$ having a large slope, a period $\beta$ having a medium slope, and a period $\gamma$ having a small slope. However, the deterioration curves 10, 20, 30, and 40 are different from each other in terms of the length of each period and the slope in each period.

As shown in Fig. 8, the deterioration curve 10 at level 1 is decomposed into a deterioration curve 11 according to the deterioration characteristic A, a deterioration curve 12 according to the deterioration characteristic B, and a deterioration curve 13 according to the deterioration characteristic C. The deterioration curve 10 is a sum of the deterioration curve 11, the deterioration curve 12, and the deterioration curve 13. The deterioration curve 11 reaches an upper limit in the period $\alpha$, and has a slope of zero in the period $\beta$ and the period $\gamma$. The deterioration curve 12 reaches upper limits in the period $\alpha$ and the period $\beta$, and has a slope of zero in the period $\gamma$. The deterioration curve 13 has no upper limit. There are numerous methods for decomposing the deterioration curve 10 at level 1 into the deterioration curves 11, 12, and 13. That is, there are numerous candidates of the deterioration curve 11. There are numerous candidates of the deterioration curve 12. There are numerous candidates of the deterioration curve 13.

Similarly, the deterioration curve 20 at level 2 is decomposed into a deterioration curve according to the deterioration characteristic A, a deterioration curve according to the deterioration characteristic B, and a deterioration curve according to the deterioration characteristic C. At level 2, there are also numerous candidates of the deterioration curve according to the deterioration characteristic A. There are an infinite number of deterioration curve candidates according to the deterioration characteristic B. There are an infinite number of deterioration curve candidates according to the deterioration characteristic C. The same applies to levels 3 and 4.

At any of level 1 to level 4, the deterioration curve according to the deterioration characteristic A approximate to experimental data is selected from among an infinite number of candidates by trial and error or fitting. Similarly, at any of level 1 to level 4, the deterioration curve according to the deterioration characteristic B approximate to the experimental data is selected from among an infinite number of candidates. At any of level 1 to level 4, the deterioration curve according to the deterioration characteristic C approximate to the experimental data is selected from among an infinite number of candidates. Accordingly, unified models (deterioration characteristic models 123, 124, and 125) outputting the results approximate to the experimental data are obtained at any of level 1 to level 4.

By the trial and error or the fitting, coefficients of the deterioration characteristic models 123, 124, and 125, the first map data for determining first coefficients of the deterioration characteristic models 123, 124, and 125, the second map data for determining second coefficients of the deterioration characteristic models 123, 124, and 125, and the third map data for determining upper limits of the deterioration characteristic models 123 and 124 are determined.

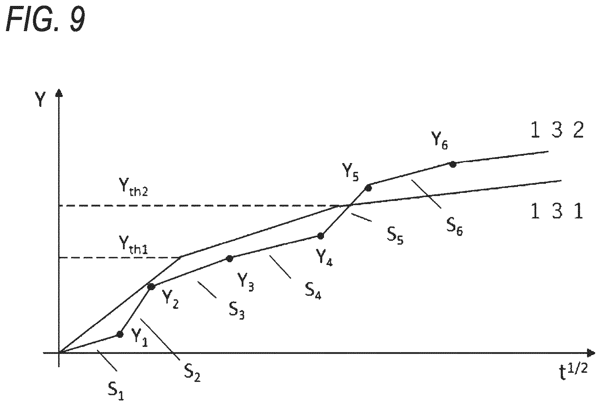

In Fig. 9, a deterioration curve 131 indicates a battery deterioration amount calculated by a battery deterioration amount determination process according to the related art. For example, in the related art, a slope of the deterioration curve 131 changes when the battery deterioration amount reaches a threshold $Y_{th1}$ and when the battery deterioration amount reaches a threshold $Y_{th2}$. A deterioration curve 132 indicates the battery deterioration amount calculated by the battery deterioration amount determination process according to the present embodiment. The deterioration curve 132 may have a different slope for each of the sampling periods $S_1$, $S_2$, $S_3$, $S_4$, $S_5$, and $S_6$. In the sampling period $S_1$, the battery deterioration amount is calculated based on battery data in the sampling period $S_1$. In the sampling period $S_2$, the battery deterioration amount is calculated based on battery data in the sampling period $S_2$.

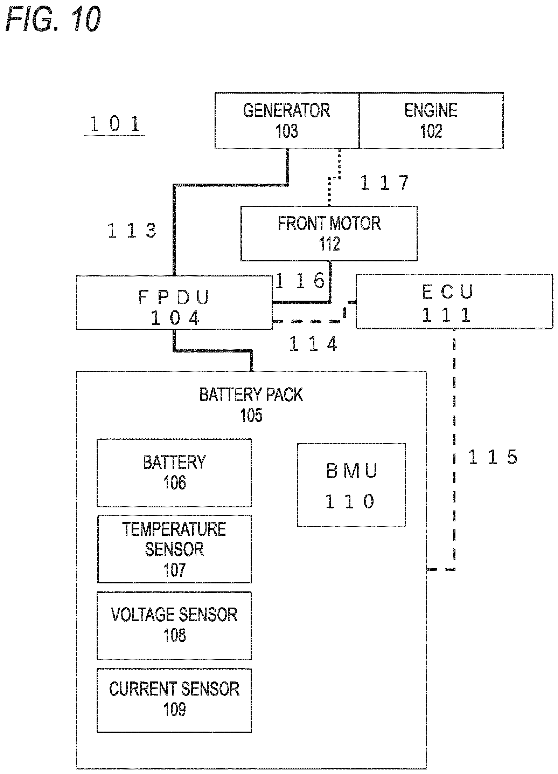

Fig. 10 shows an application example of a method for determining a battery deterioration amount according to the embodiment of the present disclosure. The method for determining a battery deterioration amount may be implemented in a vehicle 101. The vehicle 101 is, for example, an electric automobile, a hybrid automobile, a plug-in hybrid automobile capable of external charging or external power feeding, or a vehicle driven by electric power received from other batteries.

The vehicle 101 may include an engine 102 and a generator 103. The engine 102 may include an internal combustion engine that outputs rotational energy. The generator 103 may receive the rotational energy from the engine 102 and generate electric energy based on the rotational energy.

The vehicle 101 may further include a front motor drive unit (FPDU) 104, a battery pack 105, and a front motor 112. The FPDU 104 receives the electric energy from the generator 103 or the battery pack 105 via a power line 113, and applies the electric energy to the front motor 112 via a power line 116. The front motor 112 receives the electric energy, converts the electric energy into rotational energy, and gives the rotational energy to front wheels of the vehicle. The front motor 112 receives cooling 117 common to the generator 103.

The vehicle 101 may further include an electronic control unit (ECU) 111. The ECU 111 is connected to the FPDU 104 and the battery pack 105 via data lines 114 and 115, respectively.

The battery pack 105 may include a battery 106, a temperature sensor 107, a voltage sensor 108, a current sensor 109, and a battery management unit (BMU) 110. The battery 106 is, for example, a lithium ion battery. The temperature sensor 107 detects a temperature of the battery 106 and generates temperature data indicating the temperature of the battery 106. The voltage sensor 108 detects a voltage of the battery 106 and generates voltage data indicating the voltage of the battery 106. The current sensor 109 detects a current due to charging and discharging of the battery 106, and generates current data indicating the current of the battery 106. The BMU 110 is connected to the temperature sensor 107, the voltage sensor 108, and the current sensor 109. The BMU 110 acquires the temperature data from the temperature sensor 107, acquires the voltage data from the voltage sensor 108, and receives the current data from the current sensor 109. The BMU 110 generates battery data including the temperature data, the SOC data indicating the SOC of the battery 106, and the integrated current amount data indicating the integrated current amount due to the charging and discharging of the battery 106 based on the temperature data, the voltage data, and the current data. The BMU 110 performs the above-described battery deterioration amount determination process to determine a deterioration amount of the battery 106 based on the battery data.

The BMU 110 can use the deterioration amount of the battery 106 to calculate the SOC. The BMU 110 may generate deterioration amount data indicating the deterioration amount of the battery 106 and transmit the deterioration amount data to the ECU 111. The ECU 111 can receive the deterioration amount data and use the deterioration amount data to calculate a cruising distance of the vehicle 101 based on the deterioration amount of the battery 106.

The battery 106 can take different temperatures and different SOCs as the time elapses due to a time zone, a season, a region, a use situation, and other factors. In the battery deterioration amount determination process of the present embodiment, the deterioration amount of the battery 106 is determined for each sampling period based on the temperature in the sampling period and the SOC in the sampling period. The deterioration amount of the battery 106 reflects the different temperatures and the different SOCs as time elapses.

In the above embodiment, the battery includes three characteristics which are the deterioration characteristic A, the deterioration characteristic B, and the deterioration characteristic C. However, the battery is not limited thereto, and may have two characteristics or four or more characteristics.

Although various embodiments have been described above with reference to the drawings, the present invention is not limited to these examples. It is apparent to those skilled in the art that variations or modifications may be conceived within the scope described in the claims, and it is understood that the variations or modifications naturally fall within the technical scope of the present invention. In addition, the components according to the embodiment described above may be freely combined without departing from the spirit of the present invention.

The present application is based on a Japanese patent application (Japanese Patent Application No. 2022-039897) filed on March 15, 2022, and the contents thereof are incorporated herein by reference.

REFERENCE SIGNS LIST

    101: vehicle
    102: engine
    103: generator
    105: battery pack
    106: battery
    107: temperature sensor
    108: voltage sensor
    109: current sensor
    112: front motor
    113: power line
    114, 115: data line
    116: power line
    117: cooling
    120: battery deterioration amount determination process
    123: deterioration characteristic model
    124: deterioration characteristic model
    125: deterioration characteristic model
    131: deterioration curve
    132: deterioration curve

**Claims**

1.   A method for determining a battery deterioration amount comprising:

        a step of acquiring battery data including temperature data indicating a temperature of a battery, SOC data indicating an SOC of the battery, and integrated current amount data indicating an integrated current amount due to charging and discharging of the battery;

a step of calculating a first deterioration amount which is a deterioration amount of the battery according to a first deterioration characteristic based on the battery data by using a first deterioration characteristic model;

a step of calculating a second deterioration amount which is a deterioration amount of the battery according to a second deterioration characteristic based on the battery data by using a second deterioration characteristic model; and

a step of calculating a deterioration amount of the battery based on the first deterioration amount and the second deterioration amount, wherein

the first deterioration characteristic model defines an upper limit of the first deterioration amount, and

the second deterioration characteristic model does not define an upper limit of the second deterioration amount.

2. The method for determining the battery deterioration amount according to claim 1, wherein calculating the first deterioration amount includes:

a step of acquiring first period first deterioration amount data indicating a first period first deterioration amount which is a deterioration amount of the battery according to the first deterioration characteristic in a first period;

a step of calculating a second period first deterioration amount which is a deterioration amount of the battery according to the first deterioration characteristic in a second period subsequent to the first period; and

a step of adding the second period first deterioration amount to the first period first deterioration amount.

3. The method for determining the battery deterioration amount according to claim 2, wherein calculating the second deterioration amount includes:

a step of obtaining first period second deterioration amount data indicating a first period second deterioration amount which is a deterioration amount of the battery according to the second deterioration characteristic in the first period,

a step of calculating a second period second deterioration amount which is a deterioration amount of the battery according to the second deterioration characteristic in the second period, and

a step of adding the second period second deterioration amount to the first period second deterioration amount.

4. The method for determining the battery deterioration amount according to claim 2 or 3, wherein

the first deterioration characteristic model is a mathematical model including a first coefficient, and

calculating the first deterioration amount includes a step of determining the first coefficient based on the temperature of the battery and the SOC of the battery.

5. The method for determining the battery deterioration amount according to claim 4, wherein determining the first coefficient includes:

a step of acquiring first map data in which a plurality of temperature candidates related to the temperature of the battery, a plurality of SOC candidates related to the SOC of the battery, and a plurality of first coefficient candidates related to the first coefficient are associated with one another; and

a step of specifying one of the plurality of first coefficient candidates associated with a temperature candidate corresponding to the temperature indicated by the temperature data and an SOC candidate corresponding to the SOC indicated by the SOC data by using the first map data.

6. The method for determining the battery deterioration amount according to claim 5, wherein

the plurality of temperature candidates include a first temperature and a second temperature higher than the first temperature,

the plurality of SOC candidates include a first SOC and a second SOC higher than the first SOC,

the plurality of first coefficient candidates include a first candidate associated with a combination of the first temperature and the first SOC and a second candidate associated with a combination of the second temperature and the second SOC, and

the second candidate is larger than the first candidate.

7. The method for determining the battery deterioration amount according to claim 4, wherein

the first deterioration characteristic model further includes a second coefficient different from the first coefficient, and

calculating the first deterioration amount further includes:

a step of calculating a second period cycle deterioration amount which is a deterioration amount of the battery based on the integrated current amount in the second period; and

a step of determining the second coefficient based on a deterioration amount margin obtained by subtracting the second period cycle deterioration amount and the first period first deterioration amount from the upper limit of the first deterioration amount.

8. The method for determining the battery deterioration amount according to claim 7, wherein determining the second coefficient includes:

a step of acquiring second map data in which a plurality of deterioration amount margin candidates related to the deterioration amount margin and a plurality of second coefficient candidates related to the second coefficient are associated with one another; and

a step of specifying one of the plurality of second coefficient candidates associated with the deterioration amount margin candidate corresponding to the deterioration amount margin by using the second map data.

9. The method for determining the battery deterioration amount according to claim 8, wherein

the plurality of deterioration amount margin candidates include a first deterioration amount margin and a second deterioration amount margin larger than the first deterioration amount margin,

the plurality of second coefficient candidates include a first candidate associated with the first deterioration amount margin and a second candidate associated with the second deterioration amount margin, and

the second candidate is larger than the first candidate.

10. A battery management unit being configured to execute:

a process of acquiring battery data including temperature data indicating a temperature of a battery, SOC data indicating an SOC of the battery, and integrated current amount data indicating an integrated current amount due to charging and discharging of the battery;

a process of calculating a first deterioration amount which is a deterioration amount of the battery according to a first deterioration characteristic based on the battery data by using a first deterioration characteristic model;

a process of calculating a second deterioration amount which is a deterioration amount of the battery according to a second deterioration characteristic based on the battery data by using a second deterioration characteristic model; and

a process of calculating a deterioration amount of the battery based on the first deterioration amount and the second deterioration amount, wherein

the first deterioration characteristic model defines an upper limit of the first deterioration amount, and

the second deterioration characteristic model does not define an upper limit of the second deterioration amount.

11. A battery pack comprising:

a battery;

a temperature sensor configured to detect a temperature of the battery and generate temperature data indicating the temperature of the battery;

a voltage sensor configured to detect a voltage of the battery and generate voltage data indicating the voltage of the battery;

a current sensor configured to detect a current due to charging and discharging of the battery and generate current data indicating the current of the battery; and

a battery management unit connected to the temperature sensor, the voltage sensor, and the current sensor, wherein

the battery management unit is configured to:

acquire the temperature data from the temperature sensor;

acquire the voltage data from the voltage sensor;

acquire the current data from the current sensor;

generate battery data including the temperature data, SOC data indicating an SOC of the battery, and integrated current amount data indicating an integrated current amount due to charging and discharging of the battery based on the temperature data, the voltage data, and the current data;

calculate a first deterioration amount which is a deterioration amount of the battery according to a first deterioration characteristic based on the battery data by using a first deterioration characteristic model;

calculate a second deterioration amount which is a deterioration amount of the battery according to a second deterioration characteristic based on the battery data by using a second deterioration characteristic model; and

calculate a deterioration amount of the battery based on the first deterioration amount and the second deterioration amount,

the first deterioration characteristic model defines an upper limit of the first deterioration amount, and
the second deterioration characteristic model does not define an upper limit of the second deterioration amount.

# FIG. 1

120

| BATTERY DATA → | DETERIORATION CHARACTERISTIC A 123 | $Y_{a2}$ |
| BATTERY DATA → | DETERIORATION CHARACTERISTIC B 124 | $Y_{b2}$ |
| BATTERY DATA → | DETERIORATION CHARACTERISTIC C 125 | $Y_{c2}$ |

DETERIORATION AMOUNT Y OF BATTERY

# FIG. 2

FIG. 3

## FIG. 4

TEMPERATURE  LOW    T₁    T₂    HIGH

SOC

LOW

FIRST
COEFFICIENT A1

SMALL

SOC₁

FIRST
COEFFICIENT A1(1)

SOC₂

FIRST
COEFFICIENT A1(2)    LARGE

HIGH

## FIG. 5

## FIG. 6

START

ACQUIRE BATTERY DATA — S101

CALCULATE DETERIORATION AMOUNT Ya OF BATTERY ACCORDING TO DETERIORATION CHARACTERISTIC A — S102

CALCULATE DETERIORATION AMOUNT Yb OF BATTERY ACCORDING TO DETERIORATION CHARACTERISTIC B — S103

CALCULATE DETERIORATION AMOUNT Yc OF BATTERY ACCORDING TO DETERIORATION CHARACTERISTIC C — S104

CALCULATE DETERIORATION AMOUNT Y OF BATTERY BASED ON DETERIORATION AMOUNTS Ya, Yb, AND Yc — S105

END

*FIG. 7*

## FIG. 8

LEVEL 1

DETERIORATION
CHARACTERISTIC A

DETERIORATION
CHARACTERISTIC B

DETERIORATION
CHARACTERISTIC C

FIG. 9

EP 4 488 700 A1

*FIG. 10*

22

| INTERNATIONAL SEARCH REPORT | International application No. |
|---|---|
| | **PCT/JP2023/007241** |

**A. CLASSIFICATION OF SUBJECT MATTER**

*G01R 31/392*(2019.01)i; *G01R 31/374*(2019.01)i; *G01R 31/3828*(2019.01)i; *G01R 31/385*(2019.01)i; *H01M 10/42*(2006.01)i; *H01M 10/48*(2006.01)i; *H02J 7/00*(2006.01)i

FI: G01R31/392; G01R31/3828; G01R31/385; H01M10/48 301; H01M10/48 P; H01M10/42 P; H02J7/00 Y; G01R31/374

According to International Patent Classification (IPC) or to both national classification and IPC

**B. FIELDS SEARCHED**

Minimum documentation searched (classification system followed by classification symbols)

G01R31/392; G01R31/374; G01R31/3828; G01R31/385; H01M10/42; H01M10/48; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2019-66387 A (GS YUASA CORP.) 25 April 2019 (2019-04-25)<br>paragraphs [0064]-[0068] | 1-11 |
| A | JP 2016-72180 A (TOYOTA MOTOR CORP.) 09 May 2016 (2016-05-09)<br>entire text, all drawings | 1-11 |
| A | JP 2020-135188 A (TOYOTA MOTOR CORP.) 31 August 2020 (2020-08-31)<br>entire text, all drawings | 1-11 |
| A | US 2021/0072323 A1 (BATTELLE ENERGY ALLIANCE, LLC) 11 March 2021 (2021-03-11)<br>entire text, all drawings | 1-11 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **02 May 2023** | **23 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2023/007241**

| Patent document cited in search report | | | Publication date (day/month/year) | Patent family member(s) | Publication date (day/month/year) |
|---|---|---|---|---|---|
| JP | 2019-66387 | A | 25 April 2019 | US 2020/0264238 A1 paragraphs [0143]-[0162] WO 2019/069929 A1 DE 112018004450 T5 CN 111183363 A | |
| JP | 2016-72180 | A | 09 May 2016 | (Family: none) | |
| JP | 2020-135188 | A | 31 August 2020 | (Family: none) | |
| US | 2021/0072323 | A1 | 11 March 2021 | (Family: none) | |

Form PCT/ISA/210 (patent family annex) (January 2015)

**REFERENCES CITED IN THE DESCRIPTION**

**Patent documents cited in the description**

- JP 2020180935 A
- JP 2022039897 A